Europäisches Patentamt

European Patent Office

Office européen des brevets

(19)

(11) Publication number: **0 272 753 B1**

# EUROPEAN PATENT SPECIFICATION

(12)

(45) Date of publication of patent specification: **18.03.92**

(51) Int. Cl.5: **H01L 27/12**, H01L 29/72

(21) Application number: **87202540.8**

(22) Date of filing: **16.12.87**

(54) **Complementary silicon-on-insulator lateral insulated gate rectifiers.**

(30) Priority: **22.12.86 US 945417**

(43) Date of publication of application:
**29.06.88 Bulletin 88/26**

(45) Publication of the grant of the patent:
**18.03.92 Bulletin 92/12**

(84) Designated Contracting States:
**AT CH DE ES FR GB IT LI NL SE**

(56) References cited:
**EP-A- 0 144 654**

(73) Proprietor: **N.V. Philips' Gloeilampenfabrieken**
**Groenewoudseweg 1**
**NL-5621 BA Eindhoven(NL)**

(72) Inventor: **Stupp, Edward Henry**
**c/o INT. OCTROOIBUREAU B.V. Prof. Holst-**
**laan 6**
**NL-5656 AA Eindhoven(NL)**

(74) Representative: **Houbiers, Ernest Emile Marie**
**Gerlach et al**
**INTERNATIONAAL OCTROOIBUREAU B.V.**
**Prof. Holstlaan 6**
**NL-5656 AA Eindhoven(NL)**

## Description

### BACKGROUND OF THE INVENTION.

The invention is in the field of Silicon-On-Insulator (SOI) devices, and relates specifically to complementary lateral insulated gate rectifiers for use in power circuit applications such as the electronic control of discharge lamps.

Known power control circuits frequently use a half-bridge configuration, with two identical switching transistors connected in series, with the source of one transistor connected to the drain of another to form a common output terminal. This type of configuration is typically used for integrated power circuits, because the required voltage rating of the transistors is lowest. Nevertheless, there are certain disadvantages to this configuration. For example, one transistor operates as a source follower, with an inherently higher "on" resistance than a common-source configuration and higher breakdown voltage to substrate when using standard constructions. While these disadvantages may be overcome, for example by using a source follower structure, the resulting structure will be more complex and difficult to fabricate.

Another solution, typically used for discrete component circuits, uses complementary MOS FET devices in a common-drain configuration. However, such a configuration is not practical in an integrated configuration, because of fabrication difficulties and because the two devices, if integrated, would have substantially different "on" resistances, thus resulting in an unbalanced output waveform.

These disadvantages are overcome, by using a complementary MOS Lateral Insulated Gate Rectifier (LIGR) configuration which is suitable for use in power circuit configurations, which can be easily and inexpensively integrated, and which has two complementary switching devices with comparable "on" resistances.

Nevertheless, it would be desirable to obtain an LIGR construction having a simpler structural configuration, and in which substrate currents which could affect switching characteristics and control functions in a power IC device are substantially eliminated.

A complementary Silicon-On-Insulator (SOI) Lateral Insulated Gate Rectifier (LiGR), comprising two seperate LiGR sections, each having a source made of interdigitated regions of different conductivity types, is described in EP-A-0 114 654. Said LiGR sections may be interconnected by a conventional metallization atop the device structure.

### SUMMARY OF THE INVENTION.

It is therefore an object of the present invention to provide a complementary device suitable for use in power circuit applications, such as those requiring a half-bridge configuration, without the need for a source follower circuit.

Further objects of the invention are to provide a complementary device suitable for power circuit applications having a simplified structure which can be easily and inexpensively integrated, while at the same time having two complementary switching devices with comparable "on" resistances.

Yet another object of the invention is to provide a complementary device in which substrate currents, which could affect switching characteristics or the operation of the control circuiting in power IC applications, are substantially eliminated.

In accordance with the invention, these objections are achieved by a unique complementary SOI Lateral Insulated Gate Rectifier (LIGR) configuration. The LIGR is a relatively new type of device which has been found suitable for high-power switching applications. Several configurations for individual LIGR devices are shown, for example, in European Patent Application EP-A-0 111 803. As can be seen in that reference, the configuration of an individual LIGR is quite similar to that of a lateral MOS transistor, and the problems associated with integrating two such devices into a complementary integrated circuit structure are similar to those described above.

These problems have been substantially overcome by a unique integrated complementary LIGR structure, comprising a semiconductor substrate of a first conductivity type, is provided with first and second adjacent surface-adjoining semiconductor wells of a second, opposite conductivity type and with a portion of the substrate separating the two adjacent wells. Complementary LIGR elements are then fabricated in the two adjacent wells, with junction isolation to the substrate being provided by p-n junctions formed between the semiconductor wells and the semiconductor substrate, which is of opposite conductivity type to that of the wells. Such a device yields a structure which is both simpler and more easily fabricated than prior-art structures of comparable performance, but further simplification, as well as improved device-substrate isolation to limit substrate currents, would be desirable.

These further improvements are achieved by a unique integrated complementary SOI LIGR structure in accordance with the present invention, as defined in the claims. In this structure, a substantially insulating substrate having a major surface is provided with a monocrystalline silicon layer on the major surface. The monocrystalline silicon layer includes a number of adjacent, doped coplanar layer portions. A complementary SOI LIGR structure is achieved by adjacent, contacting layer portions, which form two complementary LIGR elements having a common source region. In accordance with the invention, the common source region, as well as both of the drain regions of the device, are composed of regions of both the first and second conductivity types. In this manner, a simple, easily fabricated, balanced, high performance complementary LIGR structure is obtained.

## BRIEF DESCRIPTION OF THE DRAWING.

Fig. 1 is a cross-sectional view of an SOI LIGR in accordance with the invention; and

Figs. 2, 3 and 4 are plan views of portions of the device of Fig. 1 taken along the section lines 2-2, 3-3 and 4-4, respectively, in Fig. 1.

In the drawing, semiconductor layers and regions of like conductivity type are generally hatched in the same direction. Furthermore, it should be noted that the figures are not drawn to scale, and that, in particular, dimensions in the vertical direction have been exaggerated for improved clarity.

## DESCRIPTION OF THE PREFERRED EMBODIMENT.

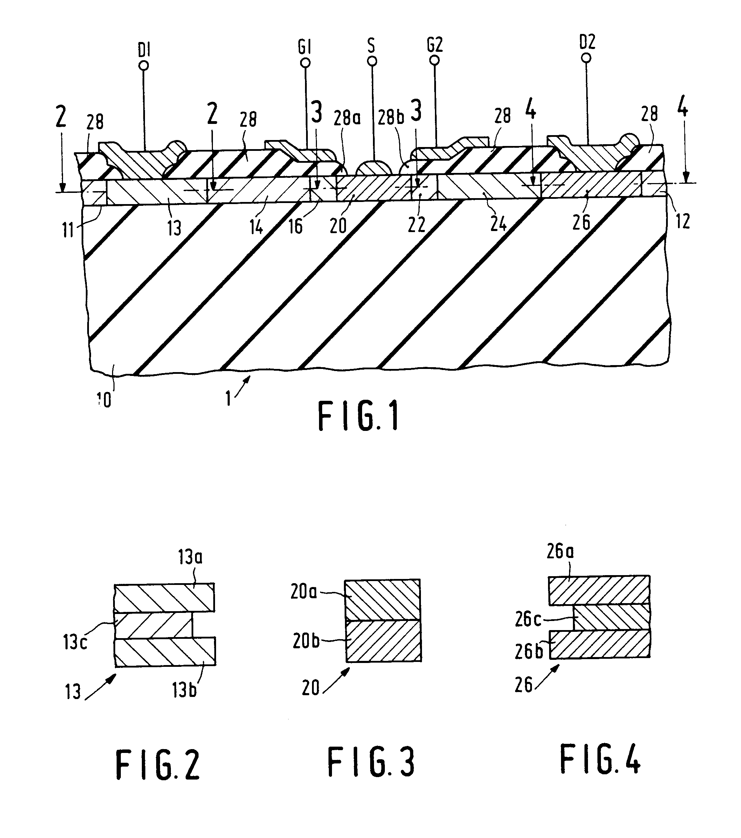

Fig. 1 of the drawing shows a complementary Silicon-On-Insulator (SOI) Lateral Insulated Gate Rectifier (LIGR) device suitable for use in power circuit applications, particularly those in which it is desired to substantially eliminate substrate currents. In Fig. 1, an SOI LIGR device 1 has a substantially insulating substrate 10 with a major surface 11. The substrate material may be selected from a number of suitable insulating materials, such as oxidized silicon, quartz, or the like, as will be apparent to those of ordinary skill in the art. A monocrystalline silicon layer 12 is provided on major surface 11 of the insulating substrate, and a number of adjacent, coplanar, doped layer portions are formed in layer 12. These adjacent layer portions form the active regions of the LIGR device, as will be described in further detail hereinafter. Silicon layer 12 may be provided by any one of a number of well-known fabrication techniques, including laser/lamp recrystallization of silicon and bond/etchback, whereby two oxidized silicon wafers are bonded in an oxidizing ambient and one of the wafers is subsequently thinned to the appropriate dimensions.

The monocrystalline silicon layer 12 may vary greatly in thickness, from less than about 100 nanometers (1000 Å) up to several micrometers, depending upon the parameters required for the specific design contemplated, and is initially of substantially undoped material prior to the formation of the doped layer portions. It is a particular advantage of the SOI technology that various parameters, such as layer thickness, can be selected over a wide range, thus making the basic structure suitable for a wide range of applications.

Monocrystalline silicon layer 12 includes a first layer portion 13, which has regions of both a first (p) and a second, opposite (n) conductivity type, which together form a first drain region of the LIGR device. The structure of the first drain region will be described in greater detail below, in connection with the description of Fig. 2. The doping level of both the p-type and n-type regions of the first layer portion is on the order of $10^{18}$ atoms/cm$^3$.

A second layer portion 14 of the first conductivity type (here p-type) is provided in contact with the regions of the first layer portion, and forms a first drift region of the LIGR device. The doping level of the p-type material of layer portion 14 is about $10^{15}$ atoms/cm$^3$. A third layer portion 16 of the second conductivity type (here n-type) is provided in contact with layer portion 14, and has a doping level of about $10^{15}$ atoms/cm$^3$. In operation, a first channel region is formed in layer portion 16. It should be noted that all of the layer portions so far described, as well as those to be described, have substantially the same thickness, as they are all obtained by appropriate doping of portions of monocrystalline silicon layer 12. As noted above, the thickness of this layer may vary from less than 100 nanometers (1000 Å) up to several micrometers, depending upon the particular application of the device to be fabricated.

A fourth layer portion 20, having regions of both the first (p) and the second (n) conductivity types is provided in contact with the third layer portion, and forms a common source region for both halves of the complementary LIGR device. The n-type and p-type regions of fourth layer portion 20 both have a doping concentration level of about $10^{18}$ atoms/cm$^3$, and are described in further detail hereinafter in connection with the description of Fig. 3, which shows a sectional plan view of fourth layer portion 20.

The second half of the LIGR device shown in Fig. 1, namely that portion of the device starting with the common source region formed by layer portion 20, is essentially a mirror image of the first portion of the device already described, but with the conductivity type of each layer portion reversed. Thus, a fifth layer portion 22 of the first (p) conductivity type is provided in contact with layer portion 20, with a second channel region being formed in this layer portion during operation. The doping concentration level of layer portion 22 is about $10^{15}$ atoms/cm$^3$, and again, this layer portion, as well as the remaining layer portions on the major surface of the insulating substrate, has the same thickness as the previously-described layers.

A sixth layer portion 24 of the second (n) conductivity type and having a doping concentration level of about $10^{15}$ atoms/cm$^3$ is provided in contact with fifth layer portion 22, and forms a second drift region of the complementary LIGR device during operation.

The portion of the device structure provided in the monocrystalline silicon layer 12 is completed by seventh layer portion 26, having regions of both the first (p) and second (n) conductivity types. Layer portion 26 is provided in contact with sixth layer portion 24, and forms a second drain region of the complementary LIGR device. The construction of seventh layer portion 26 will be described in further detail hereinafter with reference to Fig. 4, which is a sectional plan view of the second drain region.

The device structure is completed by providing an insulating layer 28 over portions of monocrystalline silicon layer 12, with insulating layer portions 28a and 28b covering at least third layer portion 16 and fifth layer portion 22, respectively. First and second gate electrodes $G_1$ and $G_2$ are then provided on insulating layer portions 28a and 28b, respectively, over layer portions 16 and 22. The device construction is completed by a source electrode S connected to fourth layer portion 20, and first and second drain electrodes $D_1$ and $D_2$ connected to first layer portion 13 and seventh layer portion 26, respectively.

As mentioned above, the layer portions 13 and 26 forming the drain regions of the complementary device, as well as layer portion 20 forming the common source region, are composed of a plurality of regions of different conductivity types. Sectional plan views of layer portions 13, 20 and 26 are shown in Figs. 2, 3 and 4, respectively. In Fig. 2, it can be seen that layer portion 13 comprises a pair of regions 13a, b of the second (n) conductivity type on either side of a region 13c of the first conductivity type, with the region 13c slightly inset from the regions 13a and 13b. It should be noted that while a three-region structure is shown in Fig. 2 for simplicity, region 13 may in fact include a larger number of such alternating regions. Similarly, layer portion 20 comprises at least one region 20a of the second (n) conductivity type and one region 20b of the first (p) conductivity type. Again, layer portion 20, shown here as having only two regions, may advantageously have additional regions of alternating conductivity types. Finally, layer portion 26, shown in Fig. 4, is essentially a mirror image of the structure shown in Fig. 2, with two regions 26a, b of the first (p) conductivity type surrounding a third region 26c of the second conductivity type. As in the case of layer portion 13, layer portion 26 may consist of further regions of alternating conductivity types, repeating the pattern shown in Fig. 4. All of the regions of layer portions 13, 20 and 26 are highly doped, with a doping concentration of about $10^{18}$ atoms/cm$^3$. It should be noted that the alternating conductivity type regions of layer portions 13, 20 and 26 do not present a serious fabrication complication, as they may be easily formed by a conventional masking process, as will be recognized by those of ordinary skill in the art.

From an operational viewpoint, the device shown in Fig. 1 can be considered as two complementary (i.e. p-channel and n-channel) LIGR devices with a common source region 20 connecting the two device elements. The operational advantages of such a device comprise both balanced "on" resistance and ease of fabrication. Additionally, by providing the active device structure on a substantially insulating substrate, substrate currents are substantially eliminated, thus enhancing switching characteristics and providing isolation from control circuitry on the same substrate.

The interdigitated drain structure of the present invention (see Figs. 2 and 4), having both p-type and n-type regions, serves the following function. At low current conduction levels between source and drain, all of the current will flow to the region of the drain having the same conductivity type as the remainder of the conductive path between source and drain. When the current increases sufficiently such that the voltage drop across the drain region exceeds 0.7 volts, then the opposite conductivity type region in the drain, which forms a p-n junction with its associated drift region, will become forward biased and will start injecting minority carriers.

In the present invention, the source region 20 also has an interdigitated construction, with at least one p-type and one n-type region, as shown in Fig. 3, with the source electrode S shown in Fig. 1 contacting both the p-type and n-type regions. The n-type region of the source, in contact with channel region 16, permits formation of a p-channel during operation, while the p-type region of the source acts as a source of holes to flow through the device to the drain. Electrons flowing from the n-type region of the drain flow through the n-type channel region and are collected through the n-type region of source 20. Operation of the right-hand element of the device, shown in the right-hand portion of Fig. 1, is analogous, except that the polarities are reversed.

In summary, the present invention provides a complementary SOI LIGR switching device which can be easily and inexpensively integrated, and which is capable of providing two complementary switching devices having comparable "on" resistances. Furthermore, these advantages are achieved without the need for a source-follower circuit, and in a device in which substrate currents are substantially eliminated.

## Claims

**1.** A complementary Silicon-On-Insulator (SOI) Lateral Insulated Gate Rectifier (LIGR), comprising:

a substantially insulating substrate having a major surface;

a monocrystalline silicon layer on said major surface, said layer comprising a plurality of adjacent coplanar, doped layer portions;

a first layer portion, having interdigitated regions of both a first and a second, opposite conductivity type and forming a first drain region of said complementary LIGR;

a second layer portion of said first conductivity type in contact with said first layer portion regions and comprising a first drift region of said complementary LIGR;

a third layer portion of said second conductivity type in contact with said second layer portion and comprising a first channel region of said complementary LIGR;

a fourth layer portion, having interdigitated regions of both said first and second conductivity types, said fourth layer portion regions being in contact with said third layer portion and forming a common source region of said complementary LIGR;

a fifth layer portion of said first conductivity type in contact with said fourth layer portion regions and comprising a second channel region of said complementary LIGR;

a sixth layer portion of said second conductivity type in contact with said fifth layer portion and comprising a second drift region of said complementary LIGR;

a seventh layer portion, having interdigitated regions of both said first and second conductivity types, said seventh layer portion regions being in contact with said sixth layer portion and forming a second drain region of said complementary LIGR;

an insulating layer over portions of said monocrystalline silicon layer and covering at least said third and fifth layer portions;

first and second gate electrodes on said insulating layer and over said third and fifth layer portions, respectively;

a source electrode connected to said fourth layer portion; and

first and second drain electrodes connected to said first and seventh layer portions, respectively.

**2.** A complementary SOI LIGR as in Claim 1, wherein said first layer portion comprises at least one region of said first conductivity type, with regions of said second conductivity type on both sides thereof, each of said first layer portion regions extending in the lateral direction to contact said second layer portion; said seventh layer portion comprises at least one region of said second conductivity type, with regions of said first conductivity type on both sides thereof, each of said seventh layer portion regions extending in the lateral direction to contact said sixth layer portion; and said fourth layer portion comprises at least one region of said first conductivity type and one region of said second conductivity type, each of said fourth layer portion regions extending in the lateral direction from said third layer portion to said fifth layer portion.

## Revendications

**1.** Redresseur latéral à grille isolée (LIGR) de type complémentaire au silicium superposé à un isolant (SOI) comportant:

un substrat sensiblement isolant présentant une surface principale;

une couche de silicium monocristallin située sur ladite surface principale et comportant une pluralité de parties de couche dopées coplanaires voisines;

une première partie de couche présentant des régions interdigitées du premier type de conductivité aussi bien que du second type de conductivité opposé et formant une première région de drain dudit LIGR;

une deuxième partie de couche dudit premier type de conductivité, en contact avec lesdites régions de la première partie de couche et comportant une première région de dérive dudit LIGR complémentaire;

une troisième partie de couche dudit second type de conductivité, en contact avec ladite deuxième partie de couche et comportant une première région de canal dudit LIGR complémentaire;

une quatrième partie de couche présentant des régions interdigitées dudit premier type de conductivité aussi bien que dudit second type de conductivité, lesdites régions de la quatrième partie de couche étant en contact avec ladite troisième partie de couche et formant une région de source commune dudit LIGR complémentaire;

une cinquième partie de couche dudit premier type de conductivité, en contact avec lesdites régions de la quatrième partie de couche et comportant une seconde région de canal dudit LIGR complémentaire,

une sixième partie de couche dudit second type de conductivité, en contact avec ladite cinquième partie de couche et comportant une seconde région de dérive dudit LIGR complémentaire;

une septième partie de couche présentant des régions interdigitées dudit premier type de conductivité aussi bien que dudit second type de conductivité, lesdites régions de la septième partie de couche étant en contact avec ladite sixième partie de couche et formant une seconde région dudit LIGR complémentaire;

une couche isolante située sur des parties de ladite couche de silicium monocristallin et recouvrant au moins lesdites troisième et cinquième parties de couche;

des première et seconde électrodes de grille superposées à ladite couche isolante et recouvrant respectivement lesdites troisième et cinquième parties de couche;

une électrode de source reliée à ladite cinquième partie de couche et

des première et seconde électrodes de drain reliées respectivement auxdites première et septième parties de couche.

2. LIGR de type complémentaire au SOI selon la revendication 1, dans lequel ladite première partie de couche comporte au moins une région dudit premier type de conductivité, avec des régions dudit second type de conductivité situées de part et d'autre de celle-ci, chacune desdites régions de la première partie de couche s'étendant dans la direction latérale de façon à mettre en contact ladite seconde partie de couche; ladite septième partie de couche comporte au moins une région dudit second type de conductivité, avec des régions dudit premier type de conductivité situées de part et d'autre de celle-ci, chacune desdites régions de la septième partie de couche s'étendant dans la direction latérale pour mettre en contact ladite sixième partie de couche; et ladite quatrième partie de couche comporte au moins une région dudit premier type de conductivité et une région dudit second type de conductivité, chacune desdites régions de la quatrième partie de couche s'étendant dans la direction latérale, à partir de ladite troisième partie de couche vers ladite cinquième partie de couche.

**Patentansprüche**

1. Komplementärer, lateraler Silizium-auf-Isolatorgleichrichter (SOI) mit isoliertem Gate (LIGR), mit:

einem im wesentlichen isolierenden Substrat mit einer Hauptfläche;

einer monokristallinen Siliziumschicht auf der genannten Hauptfläche, wobei diese Schicht eine Anzahl aneinander grenzender koplanarer dotierter Schichtteile aufweist;

einem ersten Schichtteil mit parallelgeschalteten Gebieten eines ersten bzw. zweiten, entgegengesetzten Leitungstyps, wobei dieser Teil ein erstes Drain-Gebiet des genannten komplementären LIGRs bildet;

einem zweiten Schichtteil vom genannten ersten Leitungstyp in Kontakt mit den genannten ersten Schichtteilgebieten und wobei dieser zweite Schichtteil ein erstes Triftgebiet des genannten komplementären LIGRs aufweist;

einem dritten Schichtteil vom genannten zweiten Leitungstyp in Kontakt mit dem genannten zweiten Schichtteil, wobei dieser dritte Schichtteil ein erstes Kanalgebiet des genannten komplementären LIGRs bildet;

einem vierten Schichtteil mit parallelgeschalteten Gebieten vom genannten ersten und zweiten Leitungstyp, wobei diese vierten Schichtteilgebiete mit dem genannten dritten Schichtteil in Kontakt sind und ein gemeinsames Source-Gebiet des genannten komplementären LIGRs bilden;

einem fünften Schichtteil vom genannten ersten Leitungstyp in Kontakt mit den genannten vierten Schichtteilgebieten, wobei dieser fünfte Schichtteil ein zweites Kanalgebiet des genannten komplementären LIGRs aufweist;

einem sechsten Schichtteil vom genannten zweiten Leitungstyp in Kontakt mit dem genannten fünften Schichtteil, wobei dieser sechste Schichtteil ein zweiten Triftgebiet des genannten komplementären LIGRs aufweist;

einem siebenten Schichtteil mit parallelgeschalteten Gebieten vom genannten ersten und zweiten Leitungstyp, wobei diese siebenten Schichtteilgebiete mit dem genannten sechsten Schichtteil in Kontakt sind und ein zweites Drain-Gebiet des genannten komplementären LIGRs bilden;

einer Isolierschicht über Teile der genannten monokristallinen Siliziumschicht, wobei diese Isolierschicht mindestens die genannten dritten und fünften Schichtteile bedeckt;

einer ersten und zweiten Elektrode auf der genannten Isolierschicht und über die genannten dritten bzw. fünften Schichtteile;

einer mit dem genannten vierten Schichtteil verbundenen Source-Elektrode; und

einer mit dem genannten ersten und siebenten Schichtteil verbundenen ersten bzw. zweiten Drain-Elektrode.

2. Komplementärer SOI LIGR nach Anspruch 1, wobei der genannte erste Schichtteil mindestens ein Gebiet vom genannten ersten Leitungstyp aufweist, wobei sich auf beiden Seiten desselben Gebiete vom genannten zweiten Leitungstyp befinden, wobei jedes der genannten ersten Schichtteilgebiete zur Kontaktierung des genannten zweiten Schichtteils sich in der lateralen Richtung erstreckt; wobei der genannte siebente Schichtteil mindestens ein Gebiet vom genannten zweiten Leitungstyp aufweist, wobei sich auf beiden Seiten desselben Gebiete vom genannten ersten Leitungstyp befinden, wobei jedes der genannten siebenten Schichtteilgebiete zur Kontaktierung des genannten sechsten Schichtteils sich in der lateralen Richtung erstreckt; und wobei der genannte vierte Schichtteil mindestens ein Gebiet vom genannten ersten Leitungstyp aufweist und ein Gebiet vom genannten zweiten Leitungstyp, wobei jeder der genannten vierten Schichtteilgebiete sich in lateraler Richtung von dem genannten dritten Schichtteil zu dem genannten fünften Schichtteil erstreckt.

FIG.1

FIG.2

FIG.3

FIG.4